# EUROPÄISCHE PATENTANMELDUNG

(11) **EP 1 450 182 A2**
(43) Veröffentlichungstag der Anmeldung: **25.08.2004**
(21) Anmeldenummer: 03028774.2
(22) Anmeldetag: 13.12.2003
(51) Int. Cl.: G02B 5/08, G03F 1/14

(54) **Substrat für die EUV-Mikrolithographie und Herstellverfahren hierfür**

(30) Priorität: 17.01.2003 DE 10302342
(71) Anmelder: Schott Glas, 55122 Mainz (DE); CARL-ZEISS-STIFTUNG trading as Schott Glas, 55122 Mainz (DE)
(72) Erfinder: Aschke, Lutz, 55129 Mainz (DE); Schweizer, Markus, 55270 Klein-Winternheim (DE); Alkemper, Jochen, 55270 Klein-Winternheim (DE); Schindler, Axel, 04668 Grossbothen (DE); Frost, Frost, D-04105 Leipzig (DE); Hänsel, Thomas, D-04683 Naunhof (DE); Fechner, Renate, D-04288 Leipzig (DE)
(74) Vertreter: Gahlert, Stefan, Dr.-Ing.

(57) **Zusammenfassung**

Die vorliegende Erfindung betrifft die Herstellung eines Substrates, das insbesondere für die EUV-Mikrolithographie geeignet ist und aus einer Basisschicht mit geringem thermischen Ausdehnungskoeffizienten besteht, auf die mindestens eine Deckschicht, die aus einem Halbleitermaterial, vorzugsweise aus Silizium, besteht, vorzugsweise durch Ionenstrahl-Sputtern aufgetragen ist. Durch eine zusätzliche IBF-Behandlung lassen sich äußerst formgetreue Substrate mit äußerst geringer Rauhigkeit herstellen.

## Beschreibung

Die Erfindung betrifft ein Substrat insbesondere für die EUV-Mikrolithographie, die Herstellung eines derartigen Substrats, sowie die Verwendung eines solchen Substrats für Spiegel und/oder Masken bzw. Mask-Blanks in der EUV-Mikrolithographie.

Bei der Herstellung integrierter Schaltkreise geht die Tendenz zu immer kleiner werdenden Strukturen auf den Chips. Um derartige Chips herzustellen, werden daher Lithographie-Systeme erforderlich, die mit zunehmend kleineren Belichtungswellenlängen arbeiten können. Derzeit werden Wellenlängen von 248, 193 bzw. 157 nm verwendet. Für die Zukunft ist für solche Lithographie-Systeme die Anwendung von elektromagnetischer Strahlung im sog. extremen UV-Bereich (EUV), insbesondere im Bereich von 11 bis 14 nm, vorgeschlagen worden. In diesem Bereich wird man von einem bisher üblichen Transmissionssystem auf ein Reflexionssystem mit reflektierenden optischen Elementen und Masken übergehen. Bisher sind für derartige reflektierende Systeme nur wenige Substrate für Masken und auch Spiegel für die dazugehörige Optik beschrieben worden, die den extremen Anforderungen dieser Technik genügen.

Aus der US-A-6 159 643 ist eine reflektierende Maske bekannt, die aus einer strukturierten Schicht und einem Substrat besteht, wobei das Substrat aus einer Basisschicht aus einem Material mit einem niedrigen thermischen Ausdehnungskoeffizienten, z.B. aus ULE® mit einem Ausdehnungskoeffizienten von ungefähr 0,02 ppm/K besteht und mit einer Deckschicht aus Silizium z.B. durch Kleben verbunden ist.

Mit einem derartigen Substrat lassen sich jedoch nicht die Anforderungen erfüllen, die an die Formgenauigkeit und die Oberflächenrauhigkeit des Substrats gestellt werden. So werden für Masken etwa Formabweichungen (Peak zu Valley, PV) von weniger als 50 nm PV gefordert.

Es sind auch optische Systeme auf der Basis von Zerodur®-Substraten bekannt. Dabei wurde festgestellt, daß diese zwar mit herkömmlichen Methoden auf eine Oberflächenrauhigkeit von 0,1 bis 0,3 nm poliert werden können, diese Rauhigkeit jedoch bei einem anschließend üblichen Ionenstrahlätzen (Ion Beam Figuring IBF) verlorengeht. Die Oberflächenrauhigkeit erhöht sich nach dieser Behandlung ohne besondere Vorkehrung um einen Faktor 2 bis 5. Da jedoch Oberflächenrauhigkeiten von < 0,2 nm rms für Substrate für die EUV-Lithographie angestrebt werden, ist der Einsatz derartiger Substrate für produktionstaugliche optische Systeme mit hohem Aufwand verbunden.

Der Erfindung liegt somit die Aufgabe zugrunde, ein Verfahren zur Herstellung eines Substrats anzugeben, das insbesondere für die EUV-Mikrolithographie geeignet ist. Ferner sollen ein Substrat und die Verwendung eines solchen Substrats angegeben werden, wodurch die Nachteile des Standes der Technik vermieden werden. Insbesondere soll das hergestellte Substrat in der Lage sein, die extremen Anforderungen, die an Substrate für die EUV-Mikrolithographie bezüglich der Formgenauigkeit und der Oberflächenrauhigkeit gestellt werden, zu erfüllen.

Diese Aufgabe wird durch ein Verfahren zur Herstellung eines Substrats, insbesondere für die EUV-Mikrolithographie, mit folgenden Schritten gelöst:
- Bereitstellen einer Basisschicht mit einem thermischen Ausdehnungskoeffizienten von höchstens 0,1 ppm/K,
- Auftragen einer ersten Deckschicht aus einem Halbleitermaterial, vorzugsweise aus Silizium, auf der Basisschicht durch ein physikalisches oder chemisches Auftragsverfahren, etwa durch ein Sputter-Verfahren, ein CVD-Verfahren oder ein PVD-Verfahren,
- Nachbearbeiten der ersten Deckschicht.

Hinsichtlich des Substrats wird die Aufgabe der Erfindung ferner durch ein Substrat insbesondere für die EUV-Mikrolithographie gelöst, mit einer Basisschicht und mindestens einer ersten Deckschicht, wobei die Basisschicht aus einem Material mit einem thermischen Ausdehnungskoeffizienten von höchstens 0,1 ppm/K besteht, wobei die erste Deckschicht aus einem Halbleitermaterial, insbesondere aus Silizium, besteht und auf der Basisschicht durch ein physikalisches oder chemisches Auftragsverfahren, etwa durch ein Sputter-Verfahren, ein CVD-Verfahren oder ein PVD-Verfahren, aufgetragen ist.

Ein derartiges Substrat ist vorteilhaft zur Herstellung einer Maske oder eines optischen Bauelements, wie eines Spiegels, für die EUV-Mikrolithographie einsetzbar.

Vorteilhafte Weiterbildungen der Erfindung sind in den abhängigen Ansprüchen unter Schutz gestellt.

Erfindungsgemäß wurde festgestellt, daß bei direkter Auftragung der ersten Deckschicht aus einem Halbleitermaterial, insbesondere aus Silizium, durch ein physikalisches oder chemisches Auftragsverfahren die Formgenauigkeit der Basisschicht weitgehend erhalten werden kann. Gleichzeitig wird es ermöglicht, mit Hilfe der Deckschicht die gewünschte niedrige Rauhigkeit auf der Oberfläche des Substrats zu erreichen.

Vorzugsweise wird die Deckschicht aus einem Halbleitermaterial, vorzugsweise aus Silizium, durch Ionenstrahl-Sputtern unmittelbar auf die Basisschicht aufgetragen.

Daneben kommen andere physikalische oder chemische Auftragsverfahren in Frage, wie etwa CVD ("Chemical Vapor Deposition"), insbesondere PICVD ("Plasma Impulse CVD"), PACVD ("Plasma assisted QVD"), PVD ("Physical Vapor Deposition") oder z.B, Sol-Gel-Verfahren.

Glaskeramiken wie etwa Zerodur® (SCHOTT Glas), Zerodur-M® (SCHOTT Glas), ClearCeram® (Ohara) und anderer Nullausdehnungs-Materialien wie etwa ULE® sind aufgrund ihrer extrem geringen Wärmedehnung und sehr guten Homogenität für die Anwendung als Masken und/oder Spiegel für die EUV-Lithographie besonders bevorzugt.

Erfindungsgemäß wurde festgestellt, daß der vorstehend beschriebene Nachteil von Materialien wie Glaskeramiken bzw. Keramiken durch das unmittelbare Auftragen einer Deckschicht mit geringer thermischer Ausdehnung, die ein Halbleitermaterial, insbesondere Silizium, aufweist, auf eine Basisschicht, umfassend ein Material mit einer sehr geringen Wärmeausdehnung, wie etwa eine Glaskeramik, behoben werden kann. Insbesondere kann die Basisschicht eine schlechtere Oberflächenrauhigkeit aufweisen, und es ist trotzdem möglich, die für die Mikrolithographie erforderliche Oberflächenrauhigkeit durch die Deckschicht einzustellen.

Das erfindungsgemäße Substrat weist somit mindestens eine zweischichtige Struktur auf, bestehend aus der Basisschicht und der unmittelbar darauf aufgebrachten Deckschicht.

Unter der Basisschicht wird in diesem Zusammenhang diejenige Schicht verstanden, die der späteren Substratbberfläche, beispielsweise der reflektierenden Oberfläche einer Maske oder eines Spiegels für die EUV-Lithographie, abgewandt ist.

Die Basisschicht besteht wie vorstehend erwähnt aus einem Material mit einem sehr geringen thermischen Ausdehnungskoeffizienten α (bzw. CTE) von höchstens 0,1 ppm/K, besonders bevorzugt von höchstens 10 ppb/K. Hierbei handelt es sich vorzugsweise um ein sog. "Nahe-Null-Ausdehnungsmaterial", das in einem Temperaturbereich von -40°C bis +400°C, vorzugsweise in einem Temperaturbereich von 0°C bis 50°C, im wesentlichen keine Dimensionsänderung erfährt, d.h. ein CTE von höchstens 10 ppb/K aufweist.

Vorzugsweise besteht die Basisschicht des erfindungsgemäßen Substrats aus einer Keramik, einem Glas oder einer Glaskeramik. Dabei kommen insbesondere die im Handel erhältlichen Produkte Zerodur®, Zerodur-M®, ClearCeram® (Ohara), ULE® oder andere Glaskeramiken mit geringer Wärmedehnung in Frage. Als Keramiken sind solche mit einem thermischen Ausdehnungskoeffizienten ≤ 0,1 ppm/K wie z.B. cordierithaltige Keramiken, oder dgl. geeignet.

Glaskeramiken sind anorganische, nicht poröse Materialien mit einer kristallinen Phase und einer glasigen Phase.

Erfindungsgemäß sind als Basisschicht Zerodur® und dessen Varianten (z.B. Zerodur-M®) besonders bevorzugt.

Zerodur® ist beispielsweise in der DE-A-1 902 432 beschrieben. Bei Zerodur-M® handelt es sich um eine im wesentlichen magnesiumoxidfreie Zerodur®-Zusammensetzung, die beispielsweise in der US-A-4 851 372 beschrieben ist. Eigenschaften und Zusammensetzung von Zerodur® und Zerodur-M® sind im Stand der Technik bekannt und beispielsweise in "Low Thermal Expansion Glass Ceramics", H. Bach (Herausgeber), SCHOTT Series on Glass and Glass Ceramics, Science, Technology, and Applications, Springer Verlag, beschrieben.

Es handelt sich hierbei um Glaskeramiken, die aus Gläsern aus dem System Li₂O-Al₂O₃-SiO₂ durch gezielte Kristallisation in Glaskeramiken mit Hochquartz-Mischkristallen umgewandelt werden. Die Herstellung dieser Glaskeramiken erfolgt in verschiedenen Stufen. Nach der Schmelz- und Heißformgebung wird das Material üblicherweise unter die Transformationstemperatur abgekühlt. Anschließend wird das Ausgangsglas durch gesteuerte Kristallisation in einen glaskeramischen Artikel überführt. Diese Keramisierung erfolgt in einem mehrstufigen Temperaturprozeß, bei dem zunächst durch Keimbildung bei einer Temperatur zwischen meist 600 und 800°C Keime, üblicherweise aus TiO₂ oder CrO₂/TiO₂-Mischkristallen, erzeugt werden. Bei einer anschließenden Temperaturerhöhung wachsen bei einer Kristallisationstemperatur von etwa 750 bis 900°C Hochquartz-Mischkristalle auf diesen Keimen auf. Hierbei läßt sich der Volumenanteil zwischen der kristallinen Hochquartz-Mischkristallphase und der Glasphase derart steuern, daß sich annähernd ein Ausdehnungskoeffizient von Null ergibt. Hierzu wird meist ein Anteil von etwa 80 % Hochquartz-Mischkristall und etwa 20 % Restglas angestrebt. Da die Hochquartz-Mischkristalle in dem angestrebten Temperaturbereich eine negative lineare Wärmeausdehnung aufweisen, während die der glasigen Phase positiv ist, läßt sich so in einem gewissen Temperaturbereich ein linearer thermischer Ausdehnungskoeffizient nahe Null erzielen.

Solche Glaskeramiken wie etwa Zerodur® oder Zerodur-M® werden vom Anmelder im großtechnischen Maßstab hergestellt, wobei große Glasblöcke aus dem Ausgangsglas durch eine gezielte Wärmebehandlung keramisiert werden. Dabei werden für Präzisionsanwendungen wie im vorliegenden Fall eine besonders hohe homogene Temperaturverteilung eingehalten, weshalb der Keramisierungsprozeß bei großen Blöcken von mehreren Metern Durchmesser mehrere Monate dauern kann (zwecks Einzelheiten wird auf das zuvor erwähnte Buch "Low Thermal Expansion Glass Ceramics", a.a.O. verwiesen).

Die Dicke der Basisschicht beträgt vorzugsweise mindestens 5 mm, so daß die physikalischen Eigenschaften, insbesondere deren Wärmedehnung, die des Gesamtsystems aus Basis- und Deckschicht bestimmen.

Erfindungsgemäß wird eine durch optisches Polieren vorbehandelte Basisschicht vorzugsweise zunächst mit einem Ionenstrahl unter einem bestimmten Ioneneinfallsstrahlwinkel und bestimmter Ionenstrahlenergie durch IBF bearbeitet, um die gewünschte Form einzustellen. Beispielsweise bei der Herstellung von Masken ist eine Ebenheit mit einer PV-Abweichung von < 50 nm (Peak-zu-Valley-Abweichung) angestrebt. Bei der IBF-Bearbeitung wird die zuvor erreichte niedrige Rauhigkeit von < 0,3 nm rms um einen Faktor 2 bis 3 verschlechtert.

Auf die polierte und ggf. durch IBF nachbearbeitete Basisschicht wird nunmehr eine Deckschicht aus einem Halbleitermaterial, vorzugsweise aus Si, durch ein chemisches oder physikalisches Verfahren unmittelbar aufgebracht, vorzugsweise durch ein Ionenstrahl-Sputter-Verfahren.

Beim IBF-Verfahren wird ein Ionenstrahl als Werkzeug zum Entfernen einer gewünschten Dicke von Material auf einer Oberfläche verwendet. Da die Ätzrate des Ionenstrahls gering ist (typischerweise 100 nm/min), ist dieses Verfahren nur zum Entfernen einer geringen Dicke von Material (max. einige µm) geeignet. Beim "Ion Beam Figuring" (IBF) werden quasi einzelne Atomlagen durch Ionenbeschuß entfernt.

Beim Ionenstrahl-Sputtern können die Schichtdicken ggf. lokal variiert werden, um die Formgenauigkeit des Substrats zu verbessern. Hierbei wird bei einer ersten Verfahrensvariante eine Schichtdicke zwischen 500 nm und 2 µm gewählt. Bei dieser Verfahrensvariante erfolgt anschließend eine Nachbearbeitung der Si-Deckschicht wiederum mit IBF, um die gewünschte Formgenauigkeit und Rauhigkeit zu erhalten.

Gemäß einer alternativen Ausführung der Erfindung schließt sich nach der IBF-Bearbeitung und Si-Beschichtung ein Lackplanarisierungsprozeß an, wozu ein organischer Lack verwendet wird. Dabei wird auf die Si-Deckschicht eine weitere Deckschicht aus einem organischen Lack mit einer Dicke zwischen 20 nm und 500 nm z.B. durch Spin-Coating aufgetragen und nach einem Temperprozeß die Lackschicht mittels Ionenstrahlätzen (IBF) abgetragen und planarisiert.

Bei der zweiten Verfahrensvariante mit Lackplanarisierung kann die erste Deckschicht mit einer deutlich geringeren Schichtstärke aufgetragen werden als bei der ersten Verfahrensvariante. Für die Si-Deckschicht reicht beispielsweise eine Schichtdicke von ca. 20 bis 50 nm aus, wenn eine anschließende Lackplanarisierung durchgeführt wird. Hierdurch werden die Herstellkosten gegenüber der ersten Verfahrensvariante deutlich reduziert.

Soll beispielsweise ein Maskensubstrat nach der ersten Herstellungsvariante hergestellt werden, so wird zunächst eine Glaskeramikprobe beispielsweise aus einem Block aus Zerodur® herausgetrennt, an seiner Oberfläche mechanisch bearbeitet, z.B. geschliffen, und schließlich optisch poliert, bis eine Rauhigkeit von ≤ 1 nm rms, vorzugsweise von < 0,2 nm rms, erreicht ist. Die Messung kann beispielsweise mit AFM an Stichproben von z.B. 10 µm x 10 µm oder 1 µm x 1 µm durchgeführt werden.

Anschließend wird eine Beschichtung mit Silizium mit einer Schichtdicke zwischen 500 nm und 2 µm durch ein Ionenstrahl-Sputter-Verfahren aufgebracht. Durch eine lokale Variation der Schichtdicken kann die Formgenauigkeit des Substrats verbessert werden.

Anschließend wird das beschichtete Substrat durch IBF bearbeitet, um die gewünschte Formgenauigkeit (PV-Abweichung < 50 nm) zu erreichen. Hierzu kann etwa mit Ar-Ionen mit einer Energie zwischen 500 und 1200 EV und einem Einstrahlwinkel zwischen 0 und 70° gearbeitet werden.

Auf diese Weise lassen sich Masken mit der gewünschten PV-Abweichung von < 50 nm und einer Rauhigkeit von < 0,2 nm erzielen.

Bei der Herstellung von Optiken (Spiegeln) nach der ersten Verfahrensvariante wird die vorpräparierte und polierte Basisschicht zunächst mit IBF bearbeitet, um die gewünschte Form einzustellen.

Anschließend wird die Si-Deckschicht durch Ionenstrahl-Sputtern mit einer Schichtdicke von 500 nm bis 2 µm aufgebracht und diese wiederum zur endgültigen Formgebung und zur weiteren Reduzierung der Rauhigkeit durch IBF bearbeitet.

Gemäß der zweiten Verfahrensvariante hat sich folgendes Vorgehen als besonders geeignet herausgestellt:

Zunächst werden Glaskeramik-Proben etwa aus Zerodur® wie zuvor beschrieben zugeschnitten, geschliffen und auf die gewünschte Oberflächenrauhigkeit von bevorzugt < 0,2 nm rms poliert.

Vorzugsweise erfolgt anschließend zunächst zur Einstellung der Form (Maske: PV-Abweichung < 50 nm, optische Elemente (Spiegel) < 0,3 nm rms) ein Ionenstrahlätzen IBF, wie vorstehend beschrieben.

Anschließend wird nur eine relativ dünne Si-Schicht durch Ionenstrahlsputtern aufgebracht. Hierbei reicht eine Schichtdicke von ca. 20 bis 200 nm, vorzugsweise von ca. 20 bis 50 nm, bei einer Auftragsgeschwindigkeit von ca. 10 bis 20 nm/min aus. Wie vorstehend bereits erwähnt, kann das Beschichten auch zur weiteren Einstellung der Substratebenheit genutzt werden. In diesem Fall könnte bei der vorherigen IBF-Behandlung nur eine geringere Schicht von ca. 300 nm abgetragen werden und bei der folgenden Beschichtung mit Si lokal zwischen etwa 1 und 100 nm Si aufgetragen werden.

Die aufgesputterte Si-Schicht wird anschließend durch IBF nachbearbeitet, zwecks Einhaltung der Formtreue und der Rauhigkeit.

Anschließend wird auf die Si-Deckschicht eine zweite Deckschicht aus einem organischen Lack, vorzugsweise mit einer Schichtdicke zwischen etwa 20 nm und 200 nm, etwa durch Spin-Coating aufgetragen. Die Lackschicht wird dann zunächst durch einen Temperprozeß ausgehärtet. Danach wird die Lackschicht durch IBF vollständig abgetragen, wodurch die sehr geringe Rauhigkeit auf die Si-Schicht übertragen wird.

Auf diese Weise werden mit Si-Deckschichten nur geringer Stärke reproduzierbar Oberflächenrauhigkeiten von etwa 0,1 bis 0,2 nm rms erzielt.

Anstatt der vorerwähnten Nachbearbeitung der Basisschicht bzw. der Deckschichten durch IBF kann ggf. auch ein magnetorheologisches Polieren verwendet werden.

Wie vorstehend bereits erwähnt, eignet sich das erfindungsgemäße Substrat zur Herstellung von Masken für die EUV-Lithographie. Zur Herstellung einer solchen Maske wird die Oberfläche eines erfindungsgemäßen Substrats mit einer EUV-Strahlung reflektierenden Oberfläche versehen, die durch bekannte Verfahren in eine strukturierte Maske weiter verarbeitet wird. Die erfindungsgemäßen Substrate eignen sich sowohl zur Herstellung von unstrukturierten Masken, sog. Mask-Blanks, als auch zur Herstellung von strukturierten Masken.

Die Erfindung betrifft somit sowohl Mask-Blanks, die das erfindungsgemäße Substrat und eine darauf aufgebrachte reflektierende Oberfläche aufweisen, als auch strukturierte Masken, bei denen die reflektierende Oberfläche in einer gewünschten Weise strukturiert ist.

Sofern das erfindungsgemäße Substrat zur Herstellung von optischen Elementen, wie Spiegeln für die Mikrolithographie, verwendet wird, wird auf das erfindungsgemäße Substrat eine reflektierende Beschichtung aufgebracht. Ein derartiger Spiegel kann sowohl eine ebene Oberfläche als auch eine gewölbte Oberfläche aufweisen. Um dem Spiegel eine gewölbte Oberfläche zu verleihen, kann die Basisschicht in der gewünschten Endform bereitgestellt werden. Anschließend werden die Deckschicht(en) und eine reflektierende Beschichtung aufgebracht.

## Patentansprüche

1. Verfahren zur Herstellung eines Substrates, insbesondere für die EUV-Mikrolithographie, mit folgenden Schritten:
- Bereitstellen einer Basisschicht mit einem thermischen Ausdehnungskoeffizienten von höchstens 0,1 ppm/K,
- Auftragen einer ersten Deckschicht aus einem Halbleitermaterial, vorzugsweise aus Silizium, auf der Basisschicht durch ein physikalisches oder chemisches Auftragsverfahren, etwa durch ein Sputter-Verfahren, ein CVD-Verfahren oder ein PVD-Verfahren,
- Nachbearbeiten der ersten Deckschicht.

2. Verfahren nach Anspruch 1, bei dem die erste Deckschicht durch ein Ionenstrahl-Sputter-Verfahren aufgetragen wird.

3. Verfahren nach Anspruch 1 oder 2, bei dem die Basisschicht und/oder die erste Deckschicht durch Ion Beam Figuring (IBF) bearbeitet werden.

4. Verfahren nach einem der vorhergehenden Ansprüche, bei dem die erste Deckschicht mit einer Schichtdicke von 20 nm bis 2000 nm aufgetragen wird.

5. Verfahren nach einem der vorhergehenden Ansprüche, bei dem auf die erste Deckschicht eine zweite Deckschicht aus einem Lack vorzugsweise durch Spin-Coating aufgetragen wird.

6. Verfahren nach Anspruch 5, bei dem die zweite Deckschicht mit einer Schichtdicke von 20 nm bis 500 nm aufgetragen wird.

7. Verfahren nach Anspruch 5 oder 6, bei dem die zweite Deckschicht nach ihrer Aushärtung durch IBF ganz oder teilweise abgetragen wird.

8. Verfahren nach einem der vorhergehenden Ansprüche, bei dem die Basisschicht auf eine Rauhigkeit von <1 nm rms, bevorzugt auf <0,2 nm rms poliert wird, bevor die erste Deckschicht aufgetragen wird.

9. Verfahren nach einem der vorhergehenden Ansprüche, bei dem eine Basisschicht aus Zerodur®, Zerodur-M®, ULE®, ClearCeram® oder einer cordierithaltigen Keramik verwendet wird.

10. Substrat insbesondere für die EUV-Mikrolithographie, mit einer Basisschicht und mindestens einer ersten Deckschicht, wobei die Basisschicht aus einem Material mit einem thermischen Ausdehnungskoeffizienten von höchstens 0,1 ppm/K besteht, wobei die erste Deckschicht aus einem Halbleitermaterial, insbesondere aus Silizium, besteht und auf der Basisschicht durch ein physikalisches oder chemisches Auftragsverfahren, etwa durch ein Sputter-Verfahren, ein CVD-Verfahren oder ein PVD-Verfahren, aufgetragen ist.

11. Substrat nach Anspruch 10, bei dem die erste Deckschicht eine Schichtdicke von 20 nm bis 2000 nm aufweist.

12. Substrat nach einem der Ansprüche 10 oder 11, bei dem auf der ersten Deckschicht eine zweite Deckschicht aus einem Lack vorgesehen ist.

13. Substrat nach Anspruch 12, bei dem die zweite Deckschicht eine Schichtdicke von 1 bis 200 nm, vorzugsweise von 20 bis 200 nm aufweist.

14. Substrat nach Anspruch 12 oder 13 bei dem die zweite Deckschicht durch ein Ätzverfahren zumindest teilweise abgetragen ist.

15. Substrat nach einem der Ansprüche 10 bis 14, bei dem die oberste Deckschicht eine Oberflächenrauhigkeit von höchstens 1 nm rms, vorzugsweise von <0,2 nm rms aufweist.

16. Substrat nach einem der Ansprüche 10 bis 15, bei dem die Basisschicht Zerodur®, Zerodur-M®, ULE®, ClearCeram® oder cordierithaltige Keramiken aufweist.

17. Verwendung eines Substrates nach einem der Ansprüche 10 bis 16 zur Herstellung einer Maske oder eines optischen Bauteils, insbesondere eines Spiegels, für die EUV-Mikrolithographie.
